# EUROPEAN PATENT APPLICATION

(11) **EP 1 873 862 A1**
(43) Date of publication of application: **02.01.2008**
(21) Application number: 06731508.5
(22) Date of filing: 10.04.2006
(51) Int. Cl.: H01M 14/00, H01L 31/04

(54) **ELECTROLYTE COMPOSITION FOR PHOTOELECTRIC CONVERTER AND PHOTOELECTRIC CONVERTER USING SAME**

(30) Priority: 11.04.2005 JP 2005113918
(71) Applicant: NIPPON KAYAKU KABUSHIKI KAISHA, Tokyo 102-8172 (JP)
(72) Inventor: INOUE, Teruhisa Functional Chemicals R & D Lab., Kita-ku Tokyo 1150042 (JP); HOSHI, Takayuki c/o Functional Chemicals R & D Lab, Kita-ku Tokyo 1150042 (JP); SHIGAKI, Koichiro c/o Functional Chemicals R&D Lab, Kita-ku Tokyo 1150042 (JP); KANEKO, Masayoshi c/o Functional Chemicals R&D Lab, Kita-ku Tokyo 1150042 (JP); TSUCHIDA, Teppei Research & Dvlp. Planning Div., Kita-ku Tokyo 1150042 (JP)
(74) Representative: Gille Hrabal Struck Neidlein Prop Roos
(86) International application number: PCT/JP2006/307561
(87) International publication number: WO 2006/109769

(57) **Abstract**

Disclosed is an electrolyte composition for photoelectric converters which contains a redox electrolyte pair, a room temperature molten salt and a nonionic organic solvent. This electrolyte composition for photoelectric converters is used as a charge-transporting layer in a photoelectric converter wherein a conductive support having a layer containing a dye-sensitized semiconductor and another conductive support having a counter electrode are arranged opposite to each other at a certain distance and a charge-transporting layer is sandwiched between the supports.

## Description

### Technical Field

The present invention relates to a photoelectric converter. More particularly, it relates to an electrolyte composition for photoelectric converters which is excellent in electrical properties, and to a photoelectric converter using the same.

### Background Art

Solar cells which draw attention as a clean energy source are now partly used in general houses. However, they have not yet spread sufficiently. The reasons therefor are that performances of the solar cells per se are not sufficiently satisfactory and hence the modules must be made larger, and the solar cells per se are expensive because of low productivity in production of modules.

There are several kinds of solar cells, and most of the solar cells which are put to practical use are silicon solar cells. Those which are noticed recently and studied for practical use are dye-sensitized wet-type solar cells, which have been studied for a long time. The basic structure thereof is composed of an oxide semiconductor, a dye adsorbed thereto, an electrolyte solution, a counter electrode, etc. Various kinds of dyes and electrolyte solutions have been studied, but research on semiconductors have been restricted. That is, in the initial dye-sensitized wet-type solar cells, single crystal electrodes of semiconductors are subjects for research. Specific examples of single crystal electrodes are titanium oxide (TiO₂), zinc oxide (ZnO), cadmium sulfide (CdS), tin oxide (SnO₂), etc. However, these single crystal electrodes have disadvantages that they are small in adsorbability of dyes, and hence are very low in conversion efficiency and high in cost. For solving the disadvantages, there has been proposed a high-surface area semiconductor having many pores obtained by sintering fine particles. It is reported by Tsubamura et al that electrodes containing the porous zinc oxide having an organic dye adsorbed thereon are markedly high in performance (Patent Document 1).

Thereafter, a photo (solar) cell using photoelectric converter called dye-sensitized solar cell was developed by Graetzel (Switzerland) in 1991. This is also called Graetzel cell. The structure thereof comprises a thin film substrate comprising oxide semiconductor fine particles which are sensitized with a dye and constitute one electrode and a substrate comprising a counter electrode provided with a reducing agent such as platinum are arranged opposite to each other on a transparent conductive substrate, a charge-transfer layer (an electrolyte containing a redox material) being sandwiched between the above substrates. For example, at present, a porous titanium oxide electrode to which a ruthenium complex dye is adsorbed has a performance equal to that of silicon solar cells (Non-Patent Document 1). However, as for the dye-sensitized type solar cells, no conspicuous effects to improve energy conversion efficiency have been obtained. In order to make it possible to put dye-sensitized type solar cells to practical use as a substitute for the silicon solar cells which are high in cost, further improvement of photoelectric conversion efficiency of the dye-sensitized type solar cells has been desired.

From the point of improvement in photoelectric conversion efficiency, a solution of electrolyte pair prepared by dissolving the electrolyte pair in an organic solvent has been proposed as an electrolyte medium used for a charge-transfer layer of dye-sensitized type solar cells. However, an electrochemical converter which uses an electrolyte pair solution as a charge-transfer layer has a problem that it lacks reliability due to leakage of liquid which may occur during use or storage for long period of time. Non-Patent Document 1 and Patent Document 2 disclose photoelectric converters using semiconductor fine particles sensitized with dyes and photoelectrochemical cells using the photoelectric converters. However, a solution of electrolyte pair containing an organic solvent is also used as charge-transfer layer in these photoelectric converters and photoelectrochamical cells. Therefore, the electrolyte sometimes leaks or is exhausted during use or storage for a long period of time. As a result, it is apprehended that the photoelectric conversion efficiency conspicuously lowers or it does not function as a photoelectric converter.
Under the circumstances, a photoelectric converter using a solid electrolyte pair has been proposed. For example, Patent Document 3 and Non-Patent Document 2 disclose photoelectric converters containing a solid electrolyte pair using a crosslinked polyethylene oxide polymer compound. However, the photoelectric converters using the solid electrolyte pair are insufficient in photoelectric conversion characteristics, particularly, in short circuit current density, and in addition are not satisfactory in durability.
Furthermore, it is disclosed to use pyridinium salt, imidazolium salt, triazonium salt, or the like as electrolyte pair salts in order to inhibit leakage and exhaustion of electrolyte and improve durability (Patent Document 4, Patent Document 5, etc.). These salts are in liquid state at room temperature and called room temperature molten salts. According to the above method, the durability of cells is improved because room temperature molten salts of low vapor pressure are used as solvents. However, the photoelectric converters using these room temperature molten salts have disadvantages that they are low in open circuit voltage and insufficient in photoelectric conversion efficiency.

Patent Document 1: Patent No.2664194
Patent Document 2: US Patent No.4927721
Patent Document 3: JP-A-07-288142
Patent Document 4: WO95/18456
Patent Document 5: JP-A-08-259543
Non-Patent Document 1: Nature, Vol.353, Pages 737-740, 1991
Non-Patent Document 2: J. Am. Chem. Soc. 115 (1993) 6382
Non-Patent Document 3: Solid State Ionics, 89, 263 (1996)

### Disclosure of Invention

### Problems to be solved by the Invention

A main object of the present invention is to provide an electrolyte composition which enables to realize both high photoelectric conversion efficiency and durability in dye-sensitized photoelectric converters, a photoelectric converter using the electrolyte composition as charge-transfer layer, and furthermore a solar cell using the photoelectric converter.

### Means for Solving the Problem

The inventors have conducted intensive research in an attempt to solve the above object. As a result, it has been found that the above object can be solved by specifically using as a charge-transfer layer an electrolyte composition containing a room temperature molten salt and a nonionic organic solvent. Thus, the present invention has been accomplished.

That is, the present invention relates to the following constructions.
[1] An electrolyte composition for photoelectric converters, comprising a redox electrolyte pair, a room temperature molten salt and a nonionic organic solvent, the proportion of the nonionic organic solvent to total weight of the room temperature molten salt and the nonionic organic solvent being 2-40% by weight.
[2] The electrolyte composition for photoelectric converters described in the above [1], wherein a cation forming the room temperature molten salt is a cation having a quaternary ammonium group represented by the formula (1) (wherein R₁₁, R₁₂, R₁₃ and R₁₄ independently represent a hydrogen atom, an alkyl group of 1-8 carbon atoms or an alkoxyalkyl group of 2-8 carbon atoms).

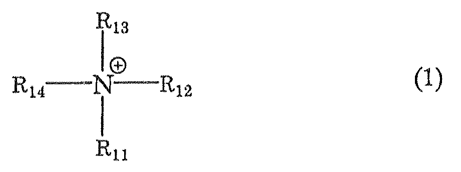

[3] The electrolyte composition for photoelectric converters described in the above [1], wherein a cation forming the room temperature molten salt is a cation having a cyclic quaternary ammonium group of five-membered ring or six-membered ring composed of one to two nitrogen atoms and atoms other than nitrogen atoms.
[4] The electrolyte composition for photoelectric converters described in the above [3], wherein the cation having a cyclic quaternary ammonium group is a cation represented by the following formula (2).

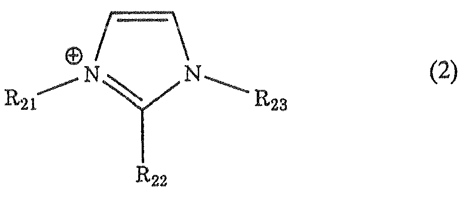

(wherein R₂₁ and R₂₂ independently of one another represent an alkyl group of 1-8 carbon atoms and R₂₃ represents a hydrogen atom or an alkyl group of 1-8 carbon atoms.)
[5] The electrolyte composition for photoelectric converters described in the above [3], wherein the cation having a cyclic quaternary ammonium group is a cation represented by the following formula (3).

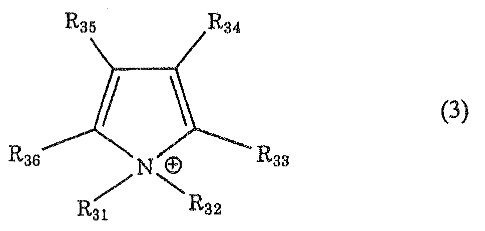

(wherein R₃₁ and R₃₂ independently of one another represent an alkyl group of 1-8 carbon atoms and R₃₃ - R₃₆ independently represent a hydrogen atom or an alkyl group of 1-8 carbon atoms).
[6] The electrolyte composition for photoelectric converters described in the above [3], wherein the cation having a cyclic quaternary ammonium group is a cation represented by the following formula (4):

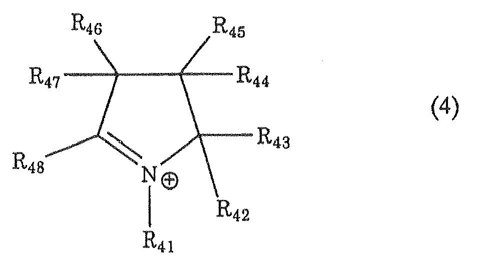

(wherein R₄₁ represents an alkyl group of 1-8 carbon atoms and R₄₂ - R₄₈ independently represent a hydrogen atom or an alkyl group of 1-8 carbon atoms).
[7] The electrolyte composition for photoelectric converters described in the above [3], wherein the cation having a cyclic quaternary ammonium group is a cation represented by the following formula (5):

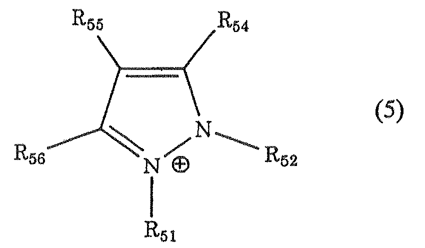

(wherein R₅₁ represents an alkyl group of 1-8 carbon atoms and R₅₂ - R₅₆ independently represent a hydrogen atom or an alkyl group of 1-8 carbon atoms).
[8] The electrolyte composition for photoelectric converters described in the above [3], wherein the cation having a cyclic quaternary ammonium group is a cation represented by the following formula (6):

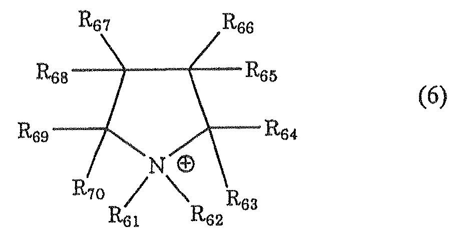

(wherein R₆₁ and R₆₂ independently of one another represent an alkyl group of 1-8 carbon atoms and R₆₃ - R₇₀ independently represent a hydrogen atom or an alkyl group of 1-8 carbon atoms).
[9] The electrolyte composition for photoelectric converters described in the above [3], wherein the cation having a cyclic quaternary ammonium group is a cation represented by the following formula (7):

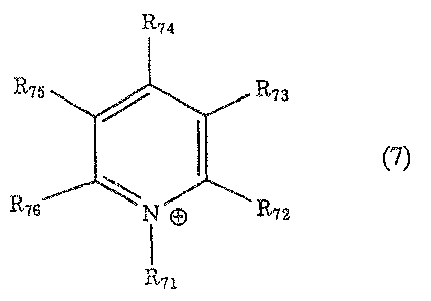

(wherein R₇₁ represents an alkyl group of 1-8 carbon atoms and R₇₂ - R₇₆ independently represent a hydrogen atom or an alkyl group of 1-8 carbon atoms.)
[10] A photoelectric converter comprising a conductive support having a semiconductor-containing layer and a conductive support having a counter electrode, the supports being arranged opposite to each other at a certain distance with a charge-transfer layer sandwiched between the supports, wherein the charge-transfer layer contains the electrolyte composition for photoelectric converter which is described in any one of the above [1]-[9].
[11] The photoelectric converter described in the above [10], wherein a semiconductor in the semiconductor-containing layer is titanium oxide.
[12] The photoelectric converter described in the above [11], wherein the titanium oxide is a modified titanium oxide.
[13] The photoelectric converter described in the above [11] or [12], wherein the titanium oxide is a particulate titanium oxide sensitized with a dye.
[14] The photoelectric converter described in the above [13], wherein the dye is a metal complex dye or a nonmetallic organic dye.
[15] A solar cell comprising the photoelectric converter described in any one of the above [10]-[14].

An electrolyte composition for photoelectric converters of the present invention is very useful for photoelectric converters, primary cells such as fuel cells, and secondary cells such as lithium cells and electric double-layer capacitors. Particularly, photoelectric converters using the electrolyte composition can take a short circuit current in a large range, and hence a high conversion efficiency can be obtained. Furthermore, since a room temperature molten salt is used, it is advantageous that no liquid leakage occurs, and durability of the photoelectric converters is improved. Therefore, solar cells obtained using the photoelectric converters are high in conversion efficiency and superior in durability, and the cost for the solar cells can be reduced.

### Best Mode for Carrying Out the Invention

The present invention will be explained in detail below.
An electrolyte composition for photoelectric converters according to the present invention contains a redox electrolyte pair, a room temperature molten salt and a nonionic organic solvent, in which the proportion of the nonionic organic solvent to total weight of the room temperature molten salt and the nonionic organic solvent is 2-40% by weight, preferably 5-40% by weight. The photoelectric converter of the present invention comprises a conductive support having a semiconductor-containing layer and a conductive support having a counter electrode, the supports being arranged opposite to each other at a certain distance with a charge-transfer layer being sandwiched between these supports. More specifically, a conductive support having a semiconductor-containing layer to which a sensitizing dye is adsorbed and a conductive support as a counter electrode are arranged opposite to each other at a certain distance, at least one of said conductive supports being a conductive support such as a transparent conductive glass, wherein a charge-transfer layer is sandwiched between these supports. The electrolyte composition for photoelectric converters of the present invention is used as the charge-transporting layer.

First, the electrolyte composition for photoelectric converters of the present invention will be explained.
The electrolyte composition is a mixture of a redox electrolyte pair, a room temperature molten salt and a nonionic organic solvent. The room temperature molten salt herein means an ionic compound at least a part of which is liquid at room temperature. The room temperature molten salt is preferably a molten salt composed of a quaternary ammonium cation and an anion comprising only a nonmetallic element. The term "room temperature" herein means a range of temperature at which a device is supposed to normally work, and the upper limit of the temperature is about 100°C, usually about 60°C, and the lower limit is about -50°C, usually about -20°C. Most of the inorganic molten salts such as Li₂CO₃-Na₂CO₃-K₂CO₃ used for various electrodepositions have a melting point of 300°C or higher. Such inorganic molten salts are not liquid in the above temperature range at which electrochemical devices are supposed to work normally, and are not included in the room temperature molten salts in the present invention.

As the cations forming the room temperature molten salts used in the present invention, preferred are cations having a quaternary ammonium group having a skeleton shown by the above formula (1), and cations having a cyclic quaternary ammonium group of 5-membered ring or 6-membered ring comprising one to two nitrogen atoms and atoms other than nitrogen atom.
R₁₁, R₁₂, R₁₃ and R₁₄ in the formula (1) independently represent a hydrogen atom, an alkyl group of 1-8 carbon atoms or an alkoxyalkyl group of 2-8 carbon atoms. The alkyl groups are preferably straight chain, branched chain or cyclic alkyl groups of 1-7 carbon atoms, more preferably straight chain alkyl groups of 1-6 carbon atoms. Specific examples of the alkyl groups are methyl, ethyl, vinyl, n-propyl, isopropyl, cyclopropyl, n-butyl, isobutyl, t-butyl, cyclobutyl, n-pentyl, 2-methylbutyl, 3-methylbutyl, 3-ethylpropyl, 2,2-dimethylpropyl, 2,3-dimethylpropyl, n-hexyl, 2-methylpentyl, 3-methylpentyl, 4-methylpentyl, 5-methylpentyl, 2,2-dimethylbutyl, 2,3-dimethylbutyl, 2,4-dimethylbutyl, 3,3-dimethylbutyl, 3,4-dimethylbutyl, 4,4-dimethylbutyl, cyclohexyl, n-heptyl, 2-methylhexyl, 3-methylhexyl, 4-methylhexyl, 5-methylhexyl, 6-methylhexyl, 2,2-dimethylpentyl, 2,3-dimethylpentyl, 2,4-dimethylpentyl, 2,5-dimethylpentyl, 3,4-dimethylpentyl, 3,5-dimethylpentyl, 4,4-dimethylpentyl, 4,5-dimethylpentyl, 5,5-dimethylpentyl, 3-ethylpentyl, 4-ethylpentyl, 5-ethylpentyl, 4-propylbutyl, n-octyl, 2-methylheptyl, 3-methylheptyl, 4-methylheptyl, 5-methylheptyl, 6-methylheptyl, 7-methylheptyl, 2,2-dimethylhexyl, 2,3-dimethylhexyl, 2,4-dimethylhexyl, 2,5-dimethylhexyl, 2,6-dimethylhexyl, 3,3-dimethylhexyl, 3,4-dimethylhexyl, 3,5-dimethylhexyl, 3,6-dimethylhexyl, 4,4-dimethylhexyl, 4,5-dimethylhexyl, 4,6-dimethylhexyl, 5,5-dimethylhexyl, 5,6-dimethylhexyl, 6,6-dimethylhexyl, 3-ethylhexyl, 4-ethylhexyl, 5-ethylhexyl, 6-ethylhexyl, 3,3-diethylbutyl, 3,4-diethylbutyl, 4,4-diethylbutyl, 4-propylpentyl, 5-propylpentyl, 2-methyl-3-isopropylbutyl, 2,2-dicyclopropylethyl, 2,2-dimethyl-(3-isopropyl)propyl, etc. Preferred alkyl groups are methyl, ethyl, n-propyl, isopropyl, n-butyl, isobutyl, t-butyl, n-pentyl, 2-methylbutyl, 3-methylbutyl, 3-ethylpropyl, 2,2-dimethylpropyl, 2,3-dimethylpropyl, n-hexyl, 2-methylpentyl, 3-methylpentyl, 4-methylpentyl, 5-methylpentyl, 2,2-dimethylbutyl, 2,3-dimethylbutyl, 2,4-dimethylbutyl, 3,3-dimethylbutyl, 3,4-dimethylbutyl, 4,4-dimethylbutyl, cyclohexyl, n-heptyl, 2-methylhexyl, 3-methylhexyl, 4-methylhexyl, 5-methylhexyl, 6-methylhexyl, 2,2-dimethylpentyl, 2,3-dimethylpentyl, 2,4-dimethylpentyl, 2,5-dimethylpentyl, 3,4-dimethylpentyl, 3,5-dimethylpentyl, 4,4-dimethylpentyl, 4,5-dimethylpentyl, 5,5-dimethylpentyl, 3-ethylpentyl, 4-ethylpentyl, 5-ethylpentyl, 4-propylbutyl, etc. More preferred are methyl, ethyl, n-propyl, isopropyl, n-pentyl and n-hexyl.
Preferred alkoxyalkyl groups are those of 2-7 carbon atoms, and more preferred are those of 3-4 carbon atoms. Specific examples of the alkoxyalkyl groups are methoxymethyl, methoxyethyl, methoxypropyl, methoxybutyl, methoxypentyl, methoxyhexyl, methoxyheptyl, ethoxymethyl, ethoxyethyl, ethoxypropyl, ethoxybutyl, ethoxypentyl, ethoxyhexyl, n-propoxymethyl, n-propoxyethyl, n-propoxyprapyl, n-propoxybutyl, n-propoxypentyl, n-butoxymethyl, n-butoxyethyl, n-butoxypropyl, n-butoxybutyl, n-pentoxymethyl, n-pentoxyethyl, n-pentoxypropyl, n-hexyloxymethyl, n-hexyloxyethyl, n-heptyloxymethyl, etc. Preferred alkoxyalkyl groups are methoxyethyl, methoxypropyl, methoxybutyl, methoxypentyl, methoxyhexyl, ethoxymethyl, ethoxyethyl, ethoxypropyl, ethoxybutyl, ethoxypentyl, n-propoxymethyl, n-propoxyethyl, n-propoxypropyl, n-propoxybutyl, n-butoxymethyl, n-butoxyethyl, n-butoxypropyl, n-pentoxymethyl, n-pentoxyethyl, n-hexyloxymethyl, etc. More preferred are methoxyethyl and methoxypropyl.

Specific examples of the cations having quaternary ammonium group represented by the formula (1) are trimethylethylammonium cation, trimethylpropylammonium cation, trimethylhexylammonium cation, tetrapentylammonium cation, methyldiethylmethoxyethylammonium, trimethylisopropylammonium cation, etc.

As the cations having a cyclic quaternary ammonium group of 5-membered ring or 6-membered ring comprising 1-2 nitrogen atoms and atoms other than nitrogen atom, cations represented by the above formulas (2) - (7) are preferred. These cations may be mixtures of two or more.

When R₂₁-R₂₃ in the formula (2) are alkyl groups (which are selected independently), specific examples of the alkyl groups are the same as those of the alkyl groups of R₁₁-R₁₄ in the formula (1). Specific examples of preferred alkyl groups of R₂₁-R₂₃ are also the same as those of the preferred alkyl groups of R₁₁-R₁₄ in the formula (1), and specific examples of more preferred alkyl groups of R₂₁-R₂₃ are also the same as those of the more preferred alkyl groups of R₁₁-R₁₄ in the formula (1).
As the imidazolium cations represented by the formula (2), imidazolium cations such as dialkylimidazolium cations and trialkylimidazolium cations are preferred. Specific examples of the dialkylimidazolium cations are 1,3-dimethylimidazolium cation, 1-ethyl-3-methylimidazolium cation, 1-methyl-3-ethylimidazolium cation, 1-methyl-3-butylimidazolium cation, 1-butyl-3-methylimidazolium cation, 1-methyl-3-propylimidazolium cation, 1-methyl-3-vinylimidazolium cation, etc. Specific examples of the trialkylimidazolium cations are 1,2,3-trimethylimidazolium cation, 1,2-dimethyl-3-ethylimidazolium cation, 1,2-dimethyl-3-propylimidazolium cation, 1-butyl-2,3-dimethylimidazolium cation, etc. They are not limited to these examples.

When R₃₁-R₃₆ in the formula (3) are alkyl groups (selected independently), specific examples of the alkyl groups are the same as those of the alkyl groups of R₁₁-R₁₄ in the formula (1). Specific examples of preferred alkyl groups of R₃₁-R₃₆ are also the same as those of the preferred alkyl groups of R₁₁-R₁₄ in the formula (1), and specific examples of more preferred alkyl groups of R₃₁-R₃₆ are also the same as those of the more preferred alkyl groups of R₁₁-R₁₄ in the formula (1).
Specific examples of the pyrrolium cations represented by the formula (3) are 1,1-dimethylpyrrolium cation, 1-ethyl-1-methylpyrrolium cation, 1-methyl-1-propylpyrrolium cation, 1-butyl-1-methylpyrrolium cation, etc. They are not limited to these examples.

When R₄₁-R₄₈ in the formula (4) are alkyl groups (selected independently), specific examples of the alkyl groups are the same as those of the alkyl groups of R₁₁-R₁₄ in the formula (1). Specific examples of preferred alkyl groups of R₄₁-R₄₈ are also the same as those of the preferred alkyl groups of R₁₁-R₁₄ in the formula (1), and specific examples of more preferred alkyl groups of R₄₁-R₄₈ are also the same as those of the more preferred alkyl groups of R₁₁-R₁₄ in the formula (1).
Specific examples of the pyrrolinium cations represented by the formula (4) are 1,2-dimethylpyrrolinium cation, 1-ethyl-2-methyl-pyrralinium cation, 1-propyl-2-methylpyrrolinium cation, 1-butyl-2-methylpyrrolinium cation, etc. They are not limited to these examples.

When R₅₁-R₅₆ in the formula (5) are alkyl groups (selected independently), specific examples of the alkyl groups are the same as those of the alkyl groups of R₁₁-R₁₄ in the formula (1). Specific examples of preferred alkyl groups of R₅₁-R₅₆ are also the same as those of the preferred alkyl groups of R₁₁-R₁₄ in the formula (1), and specific examples of more preferred alkyl groups of R₅₁-R₅₆ are also the same as those of the more preferred alkyl groups of R₁₁-R₁₄ in the formula (1).
Specific examples of the pyrazolium cations represented by the formula (5) are 1,2-dimethylpyrazolium cation, 1-ethyl-2-methylpyrazolium cation, 1-propyl-2-methylpyrazolium cation, 1-butyl-2-methylpyrazalium cation, etc. They are not limited to these examples.

When R₆₁-R₇₀ in the formula (6) are alkyl groups (selected independently), specific examples of the alkyl groups are the same as those of the alkyl groups of R₁₁-R₁₄ in the formula (1). Specific examples of preferred alkyl groups of R₆₁-R₇₀ are also the same as those of the preferred alkyl groups of R₁₁-R₁₄ in the formula (1), and specific examples of more preferred alkyl groups of R₆₁-R₇₀ are also the same as those of the more preferred alkyl groups of R₁₁-R₁₄ in the formula (1).
Specific examples of the pyrrolidinium cations represented by the formula (6) are 1,1-dimethylpyrrolidinium cation, 1-ethyl-1-methylpyrrolidinium cation, 1-methyl-1-propylpyrrolidinium cation, 1-butyl-1-methylpyrrolidinium cation, etc. They are not limited to these examples.

When R₇₁-R₇₆ in the formula (7) are alkyl groups (selected independently), specific examples of the alkyl groups are the same as those of the alkyl groups of R₁₁-R₁₄ in the formula (1). Specific examples of preferred alkyl groups of R₇₁-R₇₆ are also the same as those of the preferred alkyl groups of R₁₁-R₁₄ in the formula (1), and specific examples of more preferred alkyl groups of R₇₁-R₇₆ are also the same as those of the more preferred alkyl groups of R₁₁-R₁₄ in the formula (1).
Specific examples of the pyridinium cations represented by the formula (7) are N-methylpyridinium cation, N-ethylpyridinium cation, N-propylpyridinium cation, N-butylpyridinium cation, 1-ethyl-2-methylpyridinium cation, 1-butyl-4-methylpyridinium cation, 1-butyl-2,4-dimethylpyridinium cation, etc. They are not limited to these examples.

The cations having the quaternary ammonium group represented by the formula (1) exemplified above and the cations having the quaternary ammonium group represented by the formulas (2) to (7) exemplified above have high flame retardance. Furthermore, these cations have relatively low melting point and are liquid at room temperature, and are called ionic liquids. The electrolyte compositions prepared using room temperature molten salts obtained these cations can give not only a high ionic conductivity, but also a high flame retardance.

The room temperature molten salts used in the present invention preferably comprise each of the above cations and anions. Counter ions (anions) of the above cations are preferably selected from I⁻, BF₄⁻, PF₆⁻, SO₃⁻, CF₃SO₃⁻, N(CF₃SO₂)₂⁻, N(C₂F₅SO₂)₂⁻, N(CF₃SO₂) (C₄F₉SO₂)-, C(CF₃SO₂)₃⁻ and C(C₂F₅SO₂)₃⁻. These anions may be mixtures of two or more. By selecting these anions, room temperature molten salts of low melting point can easily be produced, which have high ionic conductivity.

In producing the room temperature molten salts from the above cations and anions, specific examples of preferred combination of each cation and anion are those shown in the following (1)-(4), but the present invention is not limited to these combinations.
(1) Combinations of N-butylpyridinium cation with tetrafluoroboric acid anion (BF₄⁻), trifluoromethanesulfonic acid anion (CF₃SO₃⁻), etc.
(2) Combinations of trimethylhexylammonium cation with trifluoromethanesulfonylamide anion (N(CF₃SO₂)₂⁻), bispentafluoroethanesulfonylamide anion (N(C₂F₅SO₂)₂⁻), etc.
(3) Combinations of 1-ethyl-3-methylimidazolium cation with tetrafluoroboric acid anion (BF₄⁻), trifluoromethanesulfonic acid anion (CF₃SO₃⁻), trifluoromethanesulfonylamide anion (N(CF₃SO₂)₂⁻), bispentafluoroethanesulfonylamide anion (N (C₂F₅SO₂)₂⁻), etc.
(4) Combinations of 1-methyl-3-butylimidazolium cation with tetrafluoroboric acid anion (BF₄⁻), hexafluorophosphoric acid anion (PF₆⁻), etc.
The room temperature molten salts used in the present invention can be prepared using each cation and anion mentioned above, for example, by mixing and stirring the cation and anion, if necessary, using a solvent such as water, and then removing the solvent used.

As the redox electrolyte pairs used in the present invention, mention may be made of a halogen redox electrolyte pair comprising a halogen compound having a halogen ion as a counter ion and a halogen molecule; a metal redox electrolyte pair comprising a ferrocyanate-ferricyanate or ferrocene-ferricinium ion, a metal complex such as cobalt complex, or the like; an organic redox electrolyte pair such as alkyl thiol-alkyl disulfide, viologen dye, hydroquinone-quinone, or the like. Among them, the halogen redox electrolyte pairs are preferred. The halogen molecules in the halogen redox electrolyte pairs include, for example, iodine molecule and bromine molecule, and iodine molecule is preferred. Furthermore, as the halogen compounds having a halogen ion as a counter ion, mention may be made of metallic halides such as LiI, NaI, KI, CsI, CaI₂, and CuI; organic quaternary ammonium salts of halogens, such as tetraalkylammonium iodide, imidazolium iodide, 1-methyl-3-alkylimidazolium iodide and pyridinium iodide; etc. Preferred are compounds (salts) having an iodine ion as a counter ion. The salts having an iodine ion as a counter ion include, for example, lithium iodide, sodium iodide, trimethylammonium iodide, etc.

The nonionic organic solvents used in the present invention are preferably liquid at room temperature and nonionic. Specific examples of the nonionic organic solvents which are liquid at room temperature are cyclic carbonic acid esters such as propylene carbonate, ethylene carbonate, butylene carbonate, chloroethylene carbonate and vinylene carbonate; cyclic esters such as γ-butyrolactone, γ-valerolactone, propiolactone and valerolactone; chain carbonates such as dimethyl carbonate, diethyl carbonate, ethylmethyl carbonate and diphenyl carbonate; chain esters such as methyl formate, methyl acetate and methyl butyrate; tetrahydrofuran or derivatives thereof; ethers such as 1,3-dioxane, 1,4-dioxane, dimethoxyethane, diethoxyethane, methoxyethoxyethane, 1,2-dimethoxyethane, 1,4-dibutoxyethane and methyl diglyme; nitriles such as acetonitrile, 3-methoxypropionitrile, methoxyacetonitrile and benzonitrile; alcohols such as ethylene glycol, propylene glycol, diethylene glycol and triethylene glycol; dioxoranes such as 1,3-dioxorane and derivatives thereof; ethylene sulfide, sulfolane, sultone, dimethylformamide, dimethyl sulfoxide, methyl formate, 2-methyltetrahydrofuran, 3-methyl-2-oxazolidinone, sulfolane, tetrahydrofuran, water, etc. Among them, preferred are acetonitrile, propylene carbonate, ethylene carbonate, 3-methoxypropionitrile, methoxyacetonitrile, ethylene glycol, 3-methyl-2-oxazolidinone, γ-butyrolactone, etc. These are used each alone or in combination of two or more.

In the electrolyte composition of the present invention, the proportion of the nonionic organic solvent to the total weight of the room temperature molten salt and the nonionic organic solvent is 2-40% by weight, preferably 5-40% by weight, more preferably 5-30% by weight. By employing such construction, the photoelectric converter obtained using the electrolyte composition shows substantially no decrease in photoelectric conversion efficiency with lapse of time and is satisfactory in stability with lapse of time. Furthermore, by employing such construction, flammability of the electrolyte composition can be lowered.
Furthermore, in the electrolyte composition of the present invention, the proportion of the room temperature molten salt to the total weight of the room temperature molten salt and the nonionic organic solvent is 98-60% by weight, preferably 95-60% by weight, more preferably 95-70% by weight. In this case, the weight molar concentration of the redox electrolyte pair is usually 0.01-40 moles by weight, preferably 0.05-20 moles by weight, more preferably 0.5-5 moles by weight.

The electrolyte composition for photoelectric converters of the present invention which contains a redox electrolyte pair, a room temperature molten salt and a nonionic organic solvent as essential components is prepared, for example, by the following various processes.That is, the redox electrolyte pair is dissolved in the nonionic organic solvent, and then the room temperature molten salt is added at a given concentration, followed by uniformly mixing, or the electrolyte pair is dissolved in the room temperature molten salt, and then the nonionic organic solvent is added thereto. The process of preparation is not limited to these processes. The redox electrolyte pair, room temperature molten salt and nonionic organic solvent may be used each alone or in combination of two or more, respectively.

For the purpose of improving durability of the photoelectric converter, the electrolyte composition of the present invention may be gelled or solidified by dissolving a low-molecular gelling agent in the composition to thicken it or by combining the composition with a polymer to form a composite. As the polymer, there may be used, for example, polyethylene oxide, polypropylene oxide, polyacrylonitrile, methyl polymethacrylate, polyvinylidene fluoride, or polymers of various monomers such as acrylic monomers, methacrylic monomers, acrylamide monomers, allyl monomers, and styrene monomers. The polymers are not limited to these examples. These may be used each alone or in combination of two or more. These reactive components may be added to the electrolyte composition and they may be reacted after a pouring operation of the electrolyte composition explained below, whereby a gel electrolyte pair can also be formed.

The electrolyte composition for photoelectric converters according to the present invention can be preferably used as a material for forming a charge-transfer layer in a photoelectric converter comprising a conductive support having a semiconductor-containing layer and a conductive support having a counter electrode which are arranged opposite to each other at a certain distance with the charge-transfer layer being interposed between the supports.

Next, an explanation will be made on the photoelectric converter in which the electrolyte composition of the present invention is used as a charge-transfer layer.

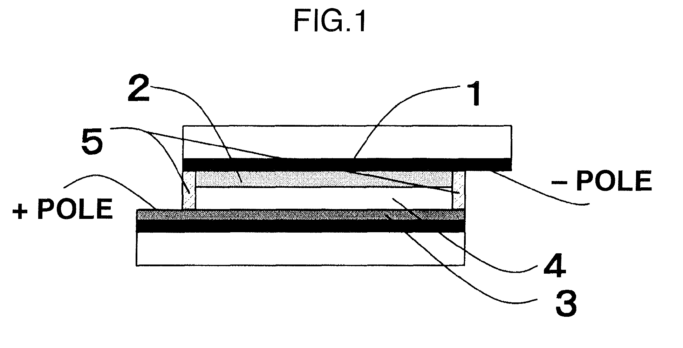

FIG. 1 is a sectional view showing schematically the essential parts of one example of the photoelectric converter according to the present invention. In FIG. 1, 1 indicates a conductive support having conductivity, 2 indicates a semiconductor-containing layer sensitized with a dye (1 and 2 are called a semiconductor electrode together), 3 indicates a counter electrode comprising a conductive support having platinum or the like on the conductive surface, 4 indicates a charge-transfer layer disposed in such a manner that it is sandwiched between the opposing conductive supports, and 5 indicates a sealing agent. In the photoelectric converter of the present invention, a semiconductor electrode comprising a conductive support having on the surface a semiconductor-containing layer sensitized with a dye and a counter electrode are arranged opposite to each other at a certain distance, the periphery of the thus arranged supports is sealed with a sealing agent, and the electrolyte composition of the present invention is enclosed in the space between the supports to form a charge-transfer layer.

Each constituting element of the photoelectric converter of the present invention will be explained below.
The semiconductor-containing layer comprises fine particles of metallic oxide semiconductor, and the metallic oxide semiconductors usable include oxides of metals of Group IIa of the periodic table, such as oxides of magnesium, calcium and strontium, transition metal oxides such as oxides of titanium, zirconium, hafnium, strontium, tantalum, chromium, molybdenum, niobium, scandium, vanadium, iron, nickel, silver, and tungsten, oxides of metals of Group IIb, such as zinc oxide, oxides of metals of Group IIIb, such as oxides of aluminum and indium, and oxides of metals of Group IVb, such as oxides of silicon and tin. Among them, fine particles of metallic oxide semiconductors such as titanium oxide, zinc oxide and tin oxide are preferred. The semiconductor fine particles of metallic oxides may be used each alone or in admixture of two or more, and the semiconductors may be modified with other materials. Commercially available metallic oxide semiconductor fine particles can be used as they are, but, for example, mixtures of zinc oxide and tin oxide may be used, or titanium oxide fine particles modified with the following metallic oxides or the like may be used.

The metallic oxides usable for modification of titanium oxide include, for example, oxides of metals of Group IIa of the periodic table, such as oxides of magnesium, calcium and strontium, transition metal oxides such as oxides of zirconium, hafnium, strontium, tantalum, chromium, molybdenum, niobium, scandium, vanadium, iron, nickel, silver and tungsten, oxides of metals of Group IIb, such as zinc oxide, oxides of metals of Group IIIb, such as oxides of aluminum and indium, and oxides of metals of Group IVb, such as oxides of silicon and tin. Among them, preferred are oxides of magnesium, calcium, strontium, zirconium, niobium and silicon. These metallic oxides may be used each alone or in combination of two or more.

Modification of titanium oxide can be carried out, for example, in the following manner.
In production of modified titanium oxide fine particles, the ratio of content of titanium oxide and metallic oxide other than titanium oxide is preferably 1/0.005-20, most preferably 1/0.01-3 in atomic ratio of titanium atom/non-titanium atom. The crystal system of titanium oxide used as a starting material in preparation of modified titanium oxide fine particles is not particularly limited, and anatase type crystal is preferred. Titanium oxide having anatase type crystal is commercially available, but can also be produced by known processes from titanium alkoxide, chloride of titanium, sulfide of titanium, nitrate of titanium, or the like. Especially preferred is use of titanium alkoxide. As solvents in these processes, there may be used water, water-soluble solvents, mixed solvents thereof or mixed solvents of water and water-soluble solvents. When the starting material is titanium alkoxide, it is preferred to use alcohols.

For producing modified titanium oxide fine particles, materials which are starting materials for modified titanium oxide fine particles such as compounds of metals constituting the above-mentioned metallic oxides, for example, a mixture comprising alkoxide, chloride, sulfide, nitrate, or the like of the metal is reacted in a solvent in a reaction vessel. The compounds of metals are preferably metallic alkoxides. As the solvent, there may be used water, water-soluble solvents or mixed solvents thereof, or mixed solvents of water and water-soluble solvent. When the starting material is metallic alkoxide, it is preferred to use alcohols.

When the starting material is metallic alkoxide, the solvent used is preferably a monohydric alcohol or a polyhydric alcohol, more preferably a polyhydric alcohol, especially preferably 1,4-butanediol. The reaction temperature is preferably about 110°C or higher and about 400°C or lower. After completion of the reaction, the desired fine particles may be obtained by an operation such as centrifugation. Furthermore, after the reaction, the valve provided at the reaction vessel is opened while keeping the temperature at about the reaction temperature to vaporize the solvent utilizing the internal pressure or, if necessary, the alcohol solvent is removed under heating, whereby the fine particles can also be obtained.

The modified titanium oxide fine particles are excellent in photocatalytic activity, and hence can be used as a catalyst for photo-oxidation reaction or a carrier for catalysts utilizing the heat resistance, and can be preferably used as a semiconductor-containing layer in dye-sensitized photoelectric converters. In the modified titanium oxide fine particles of the present invention, investigation is made on kind and proportion of metallic oxide combined with the titanium oxide, and method for compounding of the metallic compound. For example, a photoelectric converter which develops extremely high open circuit voltage can be obtained by using a photocatalyst high in catalytic activity or by sensitizing with a specific sensitizing dye.
The modified titanium oxide fine particles have been explained above. For example, fine particles of metallic oxide such as unmodified titanium oxide fine particles can also be prepared in accordance with the above-mentioned process using a metal alkoxide.

The semiconductor-containing layer comprising metallic oxide semiconductor fine particles preferably has a large surface area for adsorption of sensitizing dye mentioned hereinafter. Furthermore, for obtaining the large surface area, primary particle diameter of the metallic oxide semiconductor fine particles is preferably small. Specifically, the primary particle diameter is preferably 1-3000 nm, more preferably 5-500 nm. The surface area of the metallic oxide semiconductor fine particles can be calculated from the primary particle diameter, and is usually 0.5-1500 m²/g, preferably 3-300 m²/g. The pore volume of the metallic oxide semiconductor fine particles is preferably 0.05-0.8 ml, and moreover the average pore diameter is preferably 1-250 nm. As for the method of measurement of them, the primary particle diameter can be obtained from the surface area of the metallic oxide semiconductor fine particles which is measured, for example, by nitrogen adsorption method (BET method). The average pore diameter can also be measured by the BET method.

Next, explanation will be made on a method for providing on a conductive support a film of metallic oxide fine particles such as the above-mentioned titanium oxide fine particles or the modified titanium oxide. As the conductive support, there is used a substrate, for example, glass, plastic, polymer film, stable metal such as titanium or tantalum, or carbon on the surface of which is formed a thin film of a conductive material such as FTO (fluorine-doped tin oxide), ATO (antimony-doped tin oxide) or ITO (indium-doped tin oxide). The conductivity is usually 1000 Ω/cm² or lower, preferably 100 Ω/cm² or lower. The conductive support may be in the form of foil, film, sheet, net, punched or expanded body, lath body, porous body, foamed body, fiber formed body, etc. The thickness of the conductive support is not particularly limited, and is usually about 0.1-10 mm.

As the method for providing the semiconductor-containing layer containing metallic oxide fine particles on the conductive support (hereinafter may sometimes be called "substrate"), there are a method of producing a thin film comprising oxide semiconductor fine particles directly on the substrate by vapor deposition; a method of electrically depositing a layer of oxide semiconductor fine particles on the substrate using the substrate as an electrode; a method of preparing a slurry or paste containing metallic oxide fine particles, and applying or coating it on the substrate, followed by drying, curing or firing; and the like. Among them, the method of using slurry is preferred. The slurry is obtained by dispersing metallic oxide semiconductor fine particles which may be in the state of secondary agglomeration in a dispersion medium using a dispersant so as to give an average primary particle diameter of 1-3000 nm. Furthermore, the slurry is obtained by hydrolyzing an alkoxide which is a precursor of oxide semiconductor according to hydrolysis reaction (glycothermal method) of alkoxide in an alcohol.

The dispersants used for preparation of the slurry are not particularly limited, and any dispersants may be used so long as they can disperse the metallic oxide fine particles. Specifically, there may be used water, and nonionic organic solvents, for example, alcohols such as ethanol, ketones such as acetone and acetylacetone, hydrocarbons such as hexane, etc. These may be used in admixture, and use of water is preferred because change in viscosity of slurry decreases.

A dispersion stabilizer can be added to the slurry for the purpose of obtaining stable primary fine particles of metallic oxide. Specific examples of the dispersion stabilizer usable are polyhydric alcohols such as polyethylene glycol; condensates of polyhydric alcohols such as polyethylene glycol with phenol, octyl alcohol or the like; cellulose derivatives such as hydroxypropylmethyl cellulose, hydroxymethyl cellulose, hydroxyethyl cellulose and carboxymethyl cellulose; polyacrylamide; poly(meth)acrylic acids or salts thereof; copolymers of acrlyamides of poly(meth)acrylic acids or salts thereof with (meth)acrylic acids or alkali metal salts thereof; water-soluble polyacrylic acid derivatives which are copolymers of (a) acrylamide and/or alkali metal salts of (meth)acrylic acids and (b) (meth)acrylic acid esters such as methyl (meth)acrylates and ethyl (meth)acrylates or hydrophobic monomers such as styrene, ethylene and propylene; salts of melaminesulfonic acid-formaldehyde condensates; salts of naphthalenesulfonic acid-formaldehyde condensates; high-molecular weight lignin sulfonic acid salts; acids such as hydrochloric acid, nitric acid and acetic acid; and the like. The dispersion stabilizers are not limited to these examples. These dispersion stabilizers may be used each alone or in combination of two or more.

Among them, preferred are polyhydric alcohols such as polyethylene glycol; condensates of these polyhydric alcohols with phenol, octyl alcohol, or the like; those which have carboxyl group and/or sulfone group and/or amide group in the molecule; poly(meth)acrylic acids or salts thereof such as poly(meth)acrylic acid, sodium poly(meth)acrylate, potassium poly(meth)acrylate, and lithium poly(meth)acrylate; carboxymethyl cellulose, and acids such as hydrochloric acid, nitric acid and acetic acid.

The concentration of metallic oxide fine particles in the slurry is 1-90% by weight, preferably 5-80% by weight. The method for coating the slurry containing metallic oxide fine particles is not particularly limited. There may be employed such methods as coating with a glass rod in a desired thickness, screen printing method, spin coating method, spraying method, etc.

The substrate coated with slurry is preferably subjected to firing treatment. The firing temperature is generally not higher than melting point (or softening point) of the substrate, and is usually 100-900°C, preferably 100-600°C (but, not higher than melting point or softening point of the substrate). The firing time is preferably not more than about 4 hours. The thickness of the coated slurry on the substrate is usually 1-200 µm, preferably 3-100 µm. The thickness of layer of metallic oxide fine particles (semiconductor-containing layer) after subjected to treatments such as drying and firing is adjusted to usually 0.01-180 µm, preferably 0.05-80 µm.

The semiconductor-containing layer may be subjected to a secondary treatment with a metallic compound for improving the surface smoothness thereof (see Non-Patent Document 2). The surface smoothness can be improved by directly immersing the substrate having the layer in a solution of the metallic compound, for example, alkoxide, chloride, nitride, sulfide and acetate of the same metal as used for preparation of the metallic oxide fine particles, and drying the substrate, followed by firing, if necessary. There may be used, for example, titanium ethoxide, titanium isopropoxide and titanium-t-butoxide as the metal alkoxide, titanium tetrachloride, tin tetrachloride and zinc chloride as the chloride, and di-n-butyl-diacetyltin as the metal acetate. These metallic compounds are used in the form of solution or suspension in a solvent such as water, alcohol or the like.

Next, explanation will be made on the method for supporting a sensitizing dye on the semiconductor-containing layer provided on the conductive support as mentioned above.
A function to absorb light energy and convert it to electric energy can be imparted to the semiconductor-containing layer prepared from metallic oxide fine particles by adsorbing (supporting) a sensitizing dye onto the semiconductor-containing layer. The sensitizing dyes used are not particularly limited and there may be used any of those which sensitize light absorption in cooperation with the metallic oxide fine particles. Sensitizing dyes which are known in this field, such as metal complex dyes and nonmetallic organic dyes, can be used. The dyes may be used each alone or in admixture of several kinds of them. In the case of using them in admixture, it may be a mixture of organic dyes per se or a mixture of organic dye with metal complex dye. Particularly, by mixing dyes differing in absorption wavelength, a broad absorption wavelength can be utilized, and a dye-sensitized photoelectric converter of high conversion efficiency can be obtained. The metal complex dyes usable include, for example, ruthenium complexes, phthalocyanine dyes, porphyrin dyes, etc. The nonmetallic organic dyes include, for example, nonmetallic phthalocyanine dyes, nonmetallic porphyrin dyes, cyanine dyes, merocyanine dyes, oxonol dyes, triphenylmethane dyes, acrylic acid dyes, xanthene dyes, azo dyes, anthraquinone dyes, perylene dyes, etc. Preferred are ruthenium complexes or methine dyes such as merocyanine dyes and acrylic acid dyes. When dyes are used in admixture, the proportion of the respective dyes is not particularly limited, and optimum conditions are optionally selected depending on the respective dyes. In general, it is preferred to mix them in equimolar ratio or to use one dye in an amount of about 10 mol% or more. When the dye is supported on the semiconductor-containing layer using a solution in which two or more dyes are dissolved or dispersed, the total concentration of the dyes in the solution may be the same as in the case of supporting only one dye. As the solvent in the case of using the dyes in admixture, there may be used the following solvents, and the solvents for the respective dyes may be the same or different.

As the method for supporting the dye on the semiconductor-containing layer, mention may be made of a method of immersing a substrate provided with a semiconductor-containing layer comprising the above metallic oxide fine particles in a solution obtained by dissolving the dye in the following solvents or a dispersion obtained by dispersing the dye when the dye is low in solubility. The immersing temperature is from about 20°C to the boiling point of the solvent used. The immersing time is usually about 1-48 hours. Specific examples of the solvents usable for dissolving the dye are methanol, ethanol, acetonitrile, dimethyl sulfoxide, dimethylformamide, t-butanol, etc. The dye concentration of the solution is usually 1 × 10⁻⁶ M to 1 M, preferably 1 × 10⁻⁵ to 1 × 10⁻¹ M in molar concentration (M).

In supporting the dye on the semiconductor-containing layer comprising metallic oxide fine particles by the immersing method as mentioned above, it is effective to carry out the treatment in the coexistence of an inclusion compound in order to inhibit association of the dyes. Examples of the inclusion compound usable are cholic acids such as deoxycholic acid, chenodeoxycholic acid, methyl cholate and sodium cholate, crown ether, cyclodextrin, calixarene, polyethylene oxide, etc. Preferred are cholic acids such as deoxycholic acid, chenodeoxycholic acid, methyl cholate and sodium cholate, polyethylene oxide, etc. Furthermore, after supporting the dye, the surface of the semiconductor-containing layer may be treated with an amine compound such as 4-t-butylpyridine. The method of treatment is, for example, to immerse in an ethanolic solution of an amine the substrate provided with semiconductor-containing layer supporting the dye. After the immersion treatment and post-treatment, the solvent is removed by air-drying or heating to obtain a substrate provided with a semiconductor-containing layer which supports a dye.

In the present invention, it is also possible to form the semiconductor-containing layer by coating on the substrate the metallic oxide fine particles on which the dye has previously been supported.
The thus prepared metallic oxide fine particle thin film (semiconductor-containing layer) on which the dye is supported functions as a semiconductor electrode in the photoelectric converter of the present invention.

Next, in the photoelectric converter of the present invention, FTO conductive glass, aluminum, titanium, stainless steel, nickel, calcined carbon, conductive polymer, conductive glass, etc. are used as the counter electrode. In addition, for improving adhesion, conductivity and oxidation resistance, there may also be used a conductive support obtained by treating the surface of aluminum, copper or the like with carbon, nickel, titanium, silver or the like, on the surface of which support is vapor deposited platinum, carbon, rhodium, ruthenium or the like which has an action to catalytically assist the reduction reaction of the redox electrolyte pair. Moreover, there may also be used a counter electrode made by coating a conductive fine particle precursor, followed by firing.

The photoelectric converter of the present invention can be produced, for example, by the following method. A semiconductor-containing layer sensitized with a dye is disposed on the periphery of one conductive support, taking into consideration the sealing portion, thereby to prepare a semiconductor electrode. Then, a spacer such as glass fiber is added to an ultraviolet-curing type sealing agent for photoelectric converter. Thereafter, the sealing agent is coated on the periphery of the above semiconductor electrode leaving the portion of a pouring hole for pouring a charge-transporting layer by screen printing or using a dispenser. Then, the semiconductor electrode is heat treated, for example, at 100°C for 10 minutes to evaporate the solvent. Then, the semiconductor electrode and another conductive support provided with platinum or the like are placed one upon another in such a manner that the conductive surfaces oppose to each other, then gap of certain distance is carried by press, and then ultraviolet rays are irradiated, for example, at 3000 mJ/cm² by a high pressure mercury lamp to cure the sealing agent. If necessary, post curing may be carried out, for example, at 120°C for 10 minutes.
The space provided between the two conductive supports is for charge-transporting layer. The space is usually 1-200 µm, preferably 3-100 µm.

The electrolyte composition for photoelectric converter of the present invention is poured into the space between both conductive supports from the pouring hole to form a charge-transporting layer, and then the pouring hole is sealed, whereby the photoelectric converter of the present invention can be obtained. A lead wire is provided for the positive pole and the negative pole of the resulting photoelectric converter of the present invention, and a resistance component is inserted therebetween, whereby a solar cell of the present invention can be obtained.

### Examples

The present invention will be explained in more detail by the following examples.

### Example 1 (Preparation of electrolyte composition)

1-ethyl-3-methylimidazolium chloride and LiN(SO₂CF₃)₂ were reacted at an equimolar ratio in water to obtain 1-ethyl-3-methyl-imidazoliumbistrifluoromethanesulfonylimide. In a mixed solvent prepared by mixing the above product with 3-methoxypropionitrile (at a weight ratio of 3/1) were dissolved 1,2-dimethyl-3-propylimidazolium iodide/iodine at 0.5 M/0.05 M as a redox electrolyte pair, followed by mixing to obtain an electrolyte composition of the present invention.

### Examples 2-56 (Preparation of electrolyte compositions)

In the same manner as in Example 1, electrolyte compositions of the present invention were prepared using the components shown in Table 1. (The electrolyte composition of Example 1 is also shown in Table 1.)

**Table 1-(1) Components of electrolyte compositions (1)**

| Example | Electrolyte | Room temperature molten salt: S | Organic solvent: T | S/T | viscosity (mPas) |
|---|---|---|---|---|---|
| 1 | A | EMI⁺•TFSI⁻ | 3-MPN | 3/1 | 29 |
| 2 | A | EMI⁺•TFSI⁻ | 3-MPN | 4/1 | 33 |
| 3 | A | EMI⁺•TFSI⁻ | 3-MPN | 9/1 | 34 |
| 4 | A | EMI⁺•TFSI⁻ | PC | 3/1 | 32 |
| 5 | C | EMI⁺•TFSI⁻ | EC/AN | 8/1 | 29 |
| 6 | A | EMI⁺•TFSI⁻ | NMO | 19/1 | 29 |
| 7 | C | EMI⁺•TFSI⁻ | BC | 15/1 | 26 |
| 8 | B | EMI⁺•TFSI⁻ | γ-BL | 19/1 | 28 |
| 9 | B | EMI⁺•TFSI⁻ | EG | 5/1 | 33 |
| 10 | A | TMPA⁺•TFSI⁻ | 3-MPN | 3/1 | 59 |
| 11 | A | TMPA⁺•TFSI⁻ | EC/AN | 15/1 | 65 |
| 12 | C | TMPA⁺•TFSI⁻ | NMO | 8/1 | 53 |
| 13 | A | TMPA⁺•TFSI⁻ | γ-BL | 9/1 | 58 |
| 14 | C | TMPA⁺•TFSI⁻ | EG | 19/1 | 64 |
| 15 | A | TMPA⁺•TFSI⁻ | BC | 7/3 | 32 |
| 16 | B | TMPA⁺•TFSI⁻ | EC/AN | 5/1 | 43 |
| 17 | A | TMMMA⁺•TFSI⁻ | 3-MPN | 7/3 | 43 |
| 18 | B | TMMMA⁺•TFSI⁻ | PC | 4/1 | 37 |
| 19 | C | TMMMA⁺•TFSI⁻ | EC/AN | 19/1 | 42 |
| 20 | A | TMMMA⁺•TFSI⁻ | BC | 9/1 | 35 |
| 21 | A | TMMMA⁺•TFSI⁻ | NMO | 15/1 | 41 |
| 22 | A | BP⁺•TFSI⁻ | γ-BL | 5/2 | 45 |
| 23 | B | BP⁺•TFSI⁻ | PC | 3/2 | 45 |
| 24 | B | BP⁺•TFSI⁻ | 3-MPN | 15/1 | 40 |
| 25 | C | BP⁺•TFSI⁻ | EG | 19/1 | 49 |
| 26 | A | EMI⁺•TSAC⁻ | 3-MPN | 3/1 | 24 |
| 27 | C | EMI⁺•TSAC⁻ | MAN | 8/1 | 15 |
| 28 | B | EMI⁺•TSAC⁻ | γ-BL | 9/1 | 15 |

**Table 1-(2) Components of electrolyte compositions (2)**

| Example | Electrolyte | Room temperature molten salt: S | Organic solvent: T | S/T | Viscosity (mPas) |
|---|---|---|---|---|---|
| 29 | A | EMI⁺•TSAC⁻ | PC | 19/1 | 20 |
| 30 | B | EMI⁺•TSAC⁻ | BC | 15/1 | 18 |
| 31 | B | EMI⁺•TSAC⁻ | EC/AN | 19/1 | 21 |
| 32 | A | TMPA⁺•TSAC⁻ | 3-MPN | 5/1 | 35 |
| 33 | C | TMPA⁺•TSAC⁻ | PC | 9/1 | 31 |
| 34 | B | TMPA⁺•TSAC⁻ | EC/AN | 19/1 | 40 |
| 35 | B | TMPA⁺•TSAC⁻ | MAN | 9/1 | 20 |
| 36 | C | TMPA⁺•TSAC⁻ | NMO | 15/1 | 25 |
| 37 | A | EMP⁺•TSAC⁻ | EC/AN | 3/1 | 48 |
| 38 | A | EMP⁺•TSAC⁻ | EG | 7/3 | 33 |
| 39 | A | EMI⁺•DCA⁻ | NMO | 9/1 | 16 |
| 40 | B | EMI⁺•DCA⁻ | γ-BL | 15/1 | 15 |
| 41 | A | EMI⁺•DCA⁻ | MAN | 7/3 | 16 |
| 42 | B | EMI⁺•OCA⁻ | 3-MPN | 19/1 | 14 |
| 43 | A | MPI⁺•DCA⁻ | 3-MPN | 19/1 | 21 |
| 44 | A | MPI⁺•DCA⁻ | EG | 7/1 | 14 |
| 45 | B | MPI⁺•DCA⁻ | BC | 15/1 | 21 |
| 46 | B | MPI⁺•DCA⁻ | MAN | 15/1 | 22 |
| 47 | A | MPI⁺•I⁻ | 3-MPN | 7/3 | 175 |
| 48 | B | MPI⁺•I⁻ | EC/AN | 4/1 | 163 |
| 49 | A | MPI⁺•I⁻ | PC | 19/1 | 150 |
| 50 | C | MPI⁺•I⁻ | MAN | 9/1 | 115 |
| 51 | A | MHI⁺•I⁻ | 3-MPN | 5/2 | 280 |
| 52 | C | MHI⁺•I⁻ | NMO | 7/3 | 288 |
| 53 | A | EMI⁺•TfO⁻ | MAN | 9/1 | 134 |
| 54 | B | EMI⁺•TfO⁻ | EG | 15/1 | 237 |
| 55 | B | EMI⁺•TfO⁻ | NMO | 3/1 | 222 |
| 56 | C | EMI⁺•TfO⁻ | BC | 7/3 | 218 |

The marks and abbreviations have the following meanings.
Electrolyte pair (redox electrolyte pair)
A: 0.5 M 1,2-dimethyl-3-propylimidazolium iodide 0.05 M iodine
B: 0.5 M tetrapropylammonium iodide 0.05 M iodine
C: 0.5 M trimethylpropylammonium iodide 0.05 M iodine

Cations of room temperature molten salt (S)
EMI⁺: 1-Ethyl-3-methylimidazolium cation
TMAP⁺: Trimethylpropylammonium cation
TMMMA⁺: Trimethylmethoxymethylammonium cation
MPI⁺: 1-Methyl-3-propylimidazolium cation
MHI⁺: 1-Methyl-3-hexylimidazolium cation
BP⁺: N-Butylpyridium cation
EMP⁺: 1-Ethyl-2-methylpyrrolinium cation

Anions of room temperature molten salts (S)
TFSI⁻: N(SO₂CF₃)₂⁻; Bistrifluoromethanesulfonylimide anion
DCA⁻: N(CN)₂⁻; Dicyanoamide anion
TSAC⁻: N(SO₂CF₃) (COCF₃)⁻; Trifluoro-N-trifluoromethanesulfonylacetamide
TfO⁻: CF₃SO₃⁻; Trifluoramethanesulfonyl anion
I⁻: I⁻; Iodide anion

Organic solvents (T) (nonionic organic solvents)
3-MPN: 3-Methoxypropionitrile
PC: Propylene carbonate
EC/AN: Ethylene carbonate/acetonitrile (6/4)
NMO: 3-Methyl-2-oxazolidinone
BC: Butylene carbonate
γ-BL: γ-Butyrolactone
MAN: Methoxyacetonitrile
EG: Ethylene glycol

In Table 1, the mixing ratio (S/T) of the room temperature molten salt (S) and the organic solvent (T) is weight ratio. The viscosity was measured by a viscometer (TVE-20 manufactured by Toki Sangyo Co., Ltd.).

### Example 57 (Production of photoelectric converter)

FIG. 1 is made reference to for the example. 8 g of titanium oxide (P25: manufactured by Nippon Aerosil Co., Ltd., and having an average primary particle diameter of 21 nm) and 0.9 ml of nitric acid (dispersant) were put in a mortar, and while dispersing and kneading, 20 ml of water was added thereto and then a few drops of a dispersion stabilizer (Triton X-100 available from SIGMA-ALDRICH Japan K.K.) were added to obtain a white paste. Thereafter, this paste was uniformly coated as the semiconductor-containing layer 2 on the conductive surface of a fluorine-doped tin oxide glass (FTO glass: manufactured by Asahi Glass Co., Ltd.) as the conductive support 1 by a glass rod. The conductive support 1 coated with the semiconductor-containing layer 2 was air-dried for 1 hour and then fired at 450°C for 30 minutes to obtain a semiconductor thin film electrode (A). Thereafter, the semiconductor thin film electrode (A) left to cool to about 100°C was immersed in an EtOH solution of a dye (dye (1)) represented by the following formula (1) (3 × 10⁻⁴ M) at room temperature for one night and then washed with EtOH and air-dried. Then, the semiconductor thin film electrode (A) and a counter electrode 3 comprising a fluorine-doped tin oxide glass (FTO glass: manufactured by Asahi Glass Co., Ltd.) which was a conductive support and on the conductive surface of which a platinum layer was provided by sputtering were arranged opposite to each other with providing a space of 10 µm in such a manner that the semiconductor-containing layer 2 to which the dye was adsorbed was sandwiched between them. Then, the semiconductor-containing layer 2 to which the dye was adsorbed and the counter electrode 3 comprising a fluorine-doped tin oxide glass (FTO glass: manufactured by Asahi Glass Co., Ltd.) which was a conductive support and on the conductive surface of which a platinum layer was provided by sputtering were stuck together with a sealing agent to arrange them opposite to each other. The electrolyte composition obtained in Example 1 was poured into the space as a charge-transporting layer 4 to obtain a photoelectric converter of the present invention.

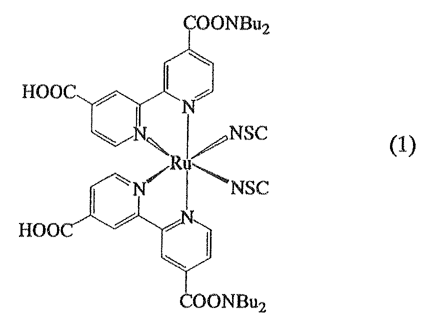

### Example 58 (Preparation of titanium oxide fine particles by sol-gel method)

Preparation of titanium oxide fine particles by sol-gel method was carried out. As a titanium alkoxide, 30 g of titanium isopropoxide was used, and this was suspended in 150 ml of water as a solvent. The suspension was charged in an autoclave of 300 ml in volume, and the autoclave was hermetically sealed. After the atmosphere in the autoclave was replaced with nitrogen, the content was heat treated at 230°C for 12 hours. After completion of the reaction, the content was left to cool to obtain a suspension containing 8.4 g of titanium oxide fine particles.
The resulting suspension of titanium oxide fine particles was made pasty with terpineol, and the paste was uniformly coated on the conductive surface of the same conductive support as in Example 57 by a glass rod, air-dried for 1 hour, and then fired at 450°C for 30 minutes to obtain a semiconductor thin film electrode (B). A photoelectric converter of the present invention was obtained under the same conditions as in Example 57, except for using the semiconductor thin film electrode (B) and the electrolyte composition obtained in Example 2 as a charge-transfer layer.

### Example 59 (Preparation of modified titanium oxide fine particles)

Preparation of modified titanium oxide fine particles (Ti/Zr) was carried out. A mixture of 25 g of titanium isopropoxide as titanium alkoxide and 18.2 g of zirconia isopropoxide as zirconia alkoxide (Ti/Zr atomic ratio = 1/0.3) was suspended in 130 ml of 1,4-butanediol as a solvent and the suspension was charged in an autoclave of 300 ml in volume, followed by sealing the autoclave. The inner atmosphere of the autoclave was replaced with nitrogen, followed by heat treating at 300°C for 2 hours. After completion of the reaction, the autoclave was left to cool to obtain 150 ml of a suspension containing 13.7 g of modified titanium oxide fine particles.
The resulting suspension of modified titanium oxide fine particles (Ti/Zr) was made pasty with terpineol, and the resulting paste was uniformly coated on the conductive surface of the same conductive support as used in Example 57 by a glass rod. The coat was air-dried for 1 hour and then fired at 450°C for 30 minutes. Thereafter, 0.05 M aqueous titanium tetrachloride solution was dropped on the modified titanium oxide fine particles to carry out a treatment at 80°C for 10 minutes, followed by firing at 450°C for 30 minutes to obtain a semiconductor thin film electrode (C). A photoelectric converter of the present invention was obtained in the same manner as in Example 57, except for using the semiconductor thin film electrode (C) and the electrolyte composition obtained in Example 3 as a charge-transfer layer.

### Production of solar cell and measurement of conversion performance

A lead wire was disposed for the positive pole and the negative pole of the photoelectric converters produced in Examples 57-59 to obtain solar cells of the present invention. These solar cells were connected to the following solar simulator (WXS-155S-10 manufactured by WACOM Co., Ltd.) to measure short circuit current, open circuit voltage and conversion efficiency. The size of the photoelectric converters used for measurement was 0.5 × 0.5 cm. As a light source, a 1000W xenon lamp (manufactured by WACOM Co., Ltd.) was used to produce an artificial sunlight (light intensity: 100 mW/cm²) by passing through a commercially available Air mass 1.5 filter.
The results of measurement of short circuit current, open circuit voltage and conversion efficiency of the solar cells are shown in Table 2.

### Examples 60-67

Photoelectric converters were produced using semiconductor thin film electrodes (A), (B) and (C) obtained in Examples 57-59, dye (1) shown by the formula (1) and dyes (2) and (3) shown by the following formulas (2) and (3), and the electrolyte compositions obtained in the above Examples (4, 7, 10, 11, 14, 21, 31 and 52), and then solar cells were made. Short circuit current, open circuit voltage and conversion efficiency of these solar cells were measured in the same manner as in Examples 57-59.

The respective constituting elements used and the results obtained are shown in Table 2.
In Table 2, the number in the column of the electrolyte composition means the number of the Example where the electrolyte composition was obtained. The number in the column of the dye means the dye (1) shown by the formula (1) and the dyes (2) and (3) shown by the formulas (2) and (3), respectively. Furthermore, (A), (B) and (C) in the column of the semiconductor thin film electrode mean the semiconductor thin film electrodes obtained in Example 57, Example 58 and Example 59, respectively.

**Table 2 Results of evaluation**

| Example | Dye | Electrolyte composition | Semiconductor thin film electrode | Short circuit current (mA/cm²) | Open circuit voltage (V) | Conversion efficiency (%) |
|---|---|---|---|---|---|---|
| 57 | (1) | 1 | (A) | 11.6 | 0.63 | 5.1 |
| 58 | (1) | 2 | (B) | 13.5 | 0.65 | 6.1 |
| 59 | (1) | 3 | (C) | 8.5 | 0.73 | 4.5 |
| 60 | (1) | 4 | (A) | 10.8 | 0.64 | 5.1 |
| 61 | (1) | 14 | (A) | 12.9 | 0.73 | 6.1 |
| 62 | (2) | 31 | (A) | 11.3 | 0.7 | 5.8 |
| 63 | (2) | 7 | (A) | 12.2 | 0.68 | 5.9 |
| 64 | (2) | 11 | (A) | 10.4 | 0.69 | 5.4 |
| 65 | (3) | 52 | (A) | 7.2 | 0.88 | 4.4 |
| 66 | (3) | 21 | (A) | 6.2 | 0.84 | 3.8 |
| 67 | (3) | 10 | (A) | 6.1 | 0.86 | 3.9 |

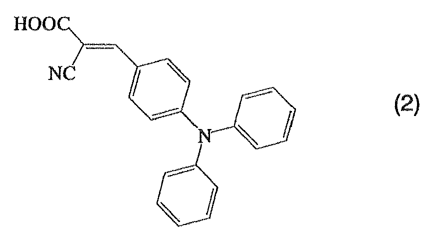

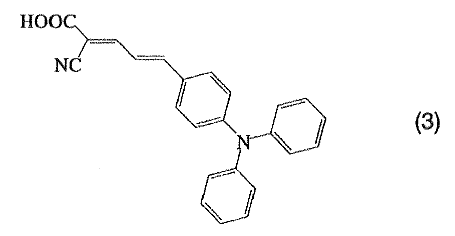

From the results of Table 2, it can be seen that the solar cells produced using the electrolyte compositions of the present invention were sufficiently high in open circuit voltage and excellent in conversion efficiency.
Moreover, when a solar cell was produced from the photoelectric converter obtained in Example 2 and subjected to daylight exposure for 80 days, the solar cell showed a conversion efficiency of 98% in initial value. Thus, it can be seen that the photoelectric converter (solar cell) of the present invention was superior in durability.

### Example 68

### Production of durable cell

1,2-Dimethyl-3-propylimidazalium iodide/iodine as electrolytes were dissolved and mixed at 0.5 M/0.05 M in a mixed solvent prepared by mixing 1-ethyl-3-methylimidazoliumbistrifluoromethanesulfonylimide and 3-methyl-2-oxazolidinone (9/1 in weight ratio) to obtain an electrolyte composition (which was the same as that of Example 6 except for the ratio of room temperature molten salt/nonionic organic solvent). As in Example 57, a pouring hole for electrolyte composition was provided at the counter electrode, and the peripheries of the semiconductor thin film electrode and the counter electrode were stuck together with a sealing agent (HIMILAN (trade name), manufactured by Du pont-Mitsui Polychemicals Co., Ltd.). Then, a photoelectric converter was produced in the same manner as in Example 57, except that the above electrolyte composition as a charge-transfer layer was poured from the pouring hole, and the pouring hole was closed with a closing agent. A lead wire was provided for the positive pole and the negative pole of the photoelectric converters to obtain a solar cell. This solar cell was connected to a solar simulator (WXS-155S-10 manufactured by WACOM Co., Ltd.) to measure the conversion efficiency. The size of the photoelectric converter used for measurement was 0.5 × 0.5 cm. As a light source, a 1000W xenon lamp (manufactured by WACOM Co., Ltd.) was used to produce an artificial sunlight (light intensity: 100 mW/cm²) by passing through a commercially available Air mass 1.5 filter. The photoelectric conversion efficiency of this photoelectric converter did not greatly change for the period of operation of 60 days at a given temperature (25°C, 80°C).

### Comparative Example 1 (Same as the electrolyte composition of Example 2 of Patent Document 4 except for the molar concentration of lithium iodide/iodine)

Lithium iodide/iodine as electrolytes were dissolved and mixed at 0.2 M/0.07 M in a mixed solvent prepared by mixing 1-hexyl-3-methylimidazolium iodide and 3-methyl-2-oxazolidinone (1/2 in weight ratio) to obtain an electrolyte composition. Then, a photoelectric converter was produced in the same manner as in Example 68, except for using the above electrolyte composition as a charge-transfer layer, and the photoelectric conversion efficiency of this photoelectric converter was measured. The results of Example 68 and Comparative Example 1 are shown in Table 3.

**Table 3 Results of Example 68 and Comparative Example 1**

| 25°C | Initial value | 30 days | 60 days |
|---|---|---|---|
| Example 68 | 7.7% | 7.7% | 7.7% |
| Comparative Example 1 | 7.8% | 7.0% | 6.1% |
| | | | |

| 80°C | Initial value | 30 days | 60 days |
|---|---|---|---|
| Example 68 | 7.6% | 7.7% | 7.3% |
| Comparative Example 1 | 7.7% | 2.0% | ND |

| | | | |
|---|---|---|---|
| ND: Less than limit of detection | | | |

From the results of Table 4, it can be seen that durability at 80°C of the solar cell produced in Example 68 was markedly superior to that of Comparative Example 1.

### Industrial Applicability

The electrolyte composition for photoelectric converters of the present invention is very useful for photoelectric converters, primary cells such as fuel cells, and secondary cells such as lithium cells and electric double-layer capacitors. Particularly, photoelectric converters using the electrolyte composition, and solar cells obtained from the electrolyte converters have high practical values.

### Brief Description of the Drawing

FIG. 1 is a sectional view showing schematically the essential parts of one example of the photoelectric converter of the present invention.

### Description of Reference Numerals

- 1: Conductive support
- 2: Semiconductor-containing layer
- 3: Counter electrode provided with a platinum layer
- 4: Charge-transfer layer
- 5: Sealing agent (sealant)

## Claims

1. The electrolyte composition for photoelectric converters, comprising a redox electrolyte pair, a room temperature molten salt and a nonionic organic solvent, the proportion of the nonionic organic solvent to the total weight of the room temperature molten salt and the nonionic organic solvent being 2-40% by weight.

2. The electrolyte composition for photoelectric converters according to claim 1, wherein a cation forming the room temperature molten salt is a cation having a quaternary ammonium group represented by the formula (1): 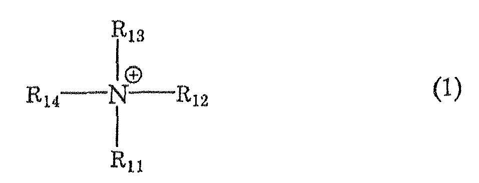 (wherein R₁₁, R₁₂, R₁₃ and R₁₄ independently represent a hydrogen atom, an alkyl group of 1-8 carbon atoms or an alkoxyalkyl group of 2-8 carbon atoms).

3. The electrolyte composition for photoelectric converters according to claim 1, wherein a cation forming the room temperature molten salt is a cation having a cyclic quaternary ammonium group of 5-membered ring or 6-membered ring composed of one to two nitrogen atoms and atoms other than nitrogen atom.

4. The electrolyte composition for photoelectric converters according to claim 3, wherein the cation having a cyclic quaternary ammonium group is a cation represented by the following formula (2): 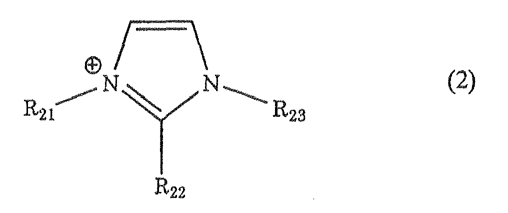 (wherein R₂₁ and R₂₂ independently represent an alkyl group of 1-8 carbon atoms and R₂₃ represents a hydrogen atom or an alkyl group of 1-8 carbon atoms).

5. The electrolyte composition for photoelectric converters according to claim 3, wherein the cation having a cyclic quaternary ammonium group is a cation represented by the following formula (3): 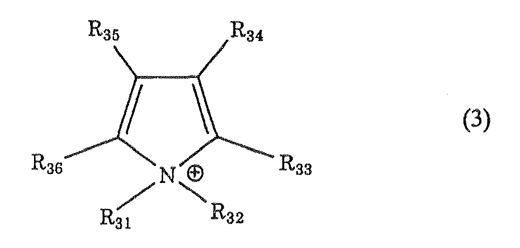 (wherein R₃₁ and R₃₂ independently represent an alkyl group of 1-8 carbon atoms and R₃₃ - R₃₆ independently represent a hydrogen atom or an alkyl group of 1-8 carbon atoms).

6. The electrolyte composition for photoelectric converters according to claim 3, wherein the cation having a cyclic quaternary ammonium group is a cation represented by the following formula (4): 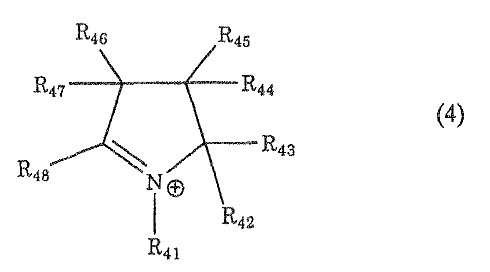 (wherein R₄₁ represents an alkyl group of 1-8 carbon atoms and R₄₂ - R₄₈ independently represent a hydrogen atom or an alkyl group of 1-8 carbon atoms).

7. The electrolyte composition for photoelectric converters according to claim 3, wherein the cation having a cyclic quaternary ammonium group is a cation represented by the following formula (5): 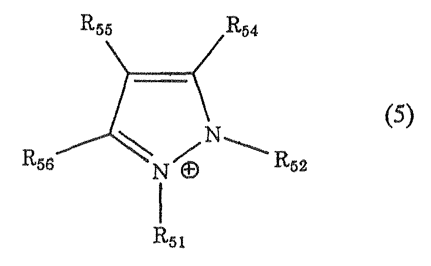 (wherein R₅₁ represents an alkyl group of 1-8 carbon atoms and R₅₂ - R₅₆ independently represent a hydrogen atom or an alkyl group of 1-8 carbon atoms).

8. The electrolyte composition for photoelectric converters according to claim 3, wherein the cation having a cyclic quaternary ammonium group is a cation represented by the following formula (6): 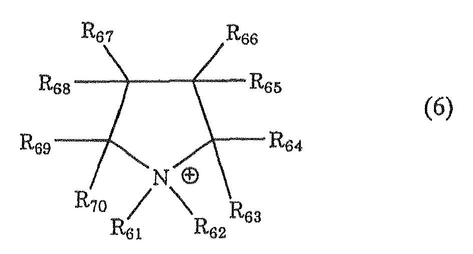 (wherein R₆₁ and R₆₂ independently represent an alkyl group of 1-8 carbon atoms and R₆₃ - R₇₀ independently represent a hydrogen atom or an alkyl group of 1-8 carbon atoms).

9. The electrolyte composition for photoelectric converters according to claim 3, wherein the cation having a cyclic quaternary ammonium group is a cation represented by the following formula (7): 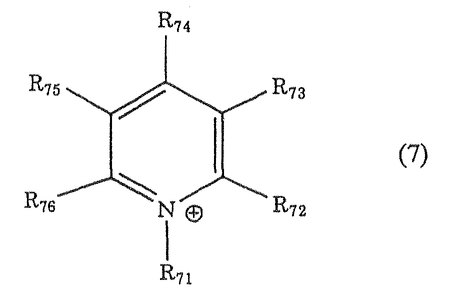 (wherein R₇₁ represents an alkyl group of 1-8 carbon atoms and R₇₂ - R₇₆ independently represent a hydrogen atom or an alkyl group of 1-8 carbon atoms).

10. A photoelectric converter comprising a conductive support having a semiconductor-containing layer and a conductive support having a counter electrode, the supports being arranged opposite to each other at a certain distance with a charge-transfer layer being sandwiched between the supports, wherein the charge-transfer layer contains the electrolyte composition for photoelectric converters according to any one of claims 1-9.

11. The photoelectric converter according to claim 10, wherein a semiconductor of the semiconductor-containing layer is titanium oxide.

12. The photoelectric converter according to claim 11, wherein the titanium oxide is a modified titanium oxide.

13. The photoelectric converter according to claim 11 or 12, wherein the titanium oxide is a particulate titanium oxide sensitized with a dye.

14. The photoelectric converter according to claim 13, wherein the dye is a metal complex dye or a nonmetallic organic dye.

15. A solar cell comprising the photoelectric converter according to any one of claims 10-14.
